(19) Europäisches Patentamt
European Patent Office
Office européen des brevets

(11) **EP 0 561 580 B1**

(12) **EUROPEAN PATENT SPECIFICATION**

(45) Date of publication and mention
of the grant of the patent:
**08.08.2001 Bulletin 2001/32**

(51) Int Cl.[7]: **H01L 29/76**, H01L 29/205,
H01L 21/334

(21) Application number: **93301928.3**

(22) Date of filing: **15.03.1993**

(54) **Charge carrier flow control device**

Ladungsträger-Durchflusskontrollanordnung

Dispositif de contrôle du flux de porteurs de charges

(84) Designated Contracting States:
**DE FR GB NL**

(30) Priority: **19.03.1992 GB 9206149**

(43) Date of publication of application:
**22.09.1993 Bulletin 1993/38**

(73) Proprietor: **HITACHI EUROPE LIMITED
Maidenhead, Berkshire, SL6 8YA (GB)**

(72) Inventor: **White, Julian D.
Histon, Cambridge, CB4 4HY (GB)**

(74) Representative: **Read, Matthew Charles et al
Venner Shipley & Co.
20 Little Britain
London EC1A 7DH (GB)**

(56) References cited:
**EP-A- 0 464 834**

• **PHYSICAL REVIEW LETTERS vol. 67, no. 12 , 16 September 1991 , NEW YORK US pages 1626 - 1629 XP240107 L. P. KOUWENHOVEN ET AL. 'QUANTIZED CURRENT IN A QUANTUM-DOT TURNSTILE USING OSCILLATING TUNNEL BARRIERS'**
• **JOURNAL OF APPLIED PHYSICS vol. 69, no. 6 , 15 March 1991 , NEW YORK US pages 3633 - 3640 XP225338 S. NAKATA ET AL. 'TRANSPORT CHARACTERISTICS OF AlGaAs/GaAs WIRES FABRICATED BY FOCUSED Ga-ION-BEAM IMPLANTATION'**

• **APPLIED PHYSICS LETTERS vol. 58, no. 23 , 10 June 1991 , NEW YORK US pages 2695 - 2697 XP233126 A. A. ODINTSOV 'SINGLE ELECTRON TRANSPORT IN A TWO-DIMENSIONAL ELECTRON GAS SYSTEM WITH MODULATED BARRIERS: A POSSIBLE DC CURRENT STANDARD'**
• **MICROCIRCUIT ENGINEERING 91 - INTERNATIONAL CONFERENCE ON MICROLITHOGRAPHY September 1991 , ROME, ITALY pages 513 - 516 XP291799 Y. JIN ET AL. 'SINGLE ELECTRON EFFECT TRANSISTOR: FABRICATION AND OBSERVATION'**
• **APPLIED PHYSICS LETTERS vol. 56, no. 10 , 5 March 1990 , NEW YORK US pages 928 - 930 XP133494 A. D. WIECK ET AL. 'IN-PLANE-GATED QUANTUM WIRE TRANSISTOR FABRICATED WITH DIRECTLY WRITTEN FOCUSED ION BEAMS'**
• **PHYSICAL REVIEW, B. SOLID STATE vol. 39, no. 8 , 15 March 1989 , NEW YORK US pages 5535 - 5537 Y. HIRAYAMA ET AL. 'ELECTRONIC TRANSPORT THROUGH VERY SHORT AND NARROW CHANNELS CONSTRICTED IN GaAs BY HIGHLY RESISTIVE Ga-IMPLANTED REGIONS'**
• **MICROELECTRONIC ENGINEERING vol. 11 , 1990 , AMSTERDAM NL pages 113 - 116 Y. JIN ET AL. 'HIGH TRANSCONDUCTANCE AI0.3Ga0.7As/GaAs MODFETs'**
• **SOLID STATE ELECTRONICS vol. 34, no. 2 , 1991 , OXFORD GB pages 117 - 121 XP168907 Y. JIN 'OHMIC CONTACT TO N TYPE BULK AND DELTA DOPED AI0.3Ga0.7As/GaAs MODFET TYPE HETEROSTRUCTURES AND ITS APPLICATIONS'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

- **MICROELECTRONIC ENGINEERING vol. 11 , 1990 , AMSTERDAM NL pages 47 - 50 XP134565 P. GRAMBOW ET AL. 'PREPARATION OF QUANTUM WIRES AND QUANTUM DOTS BY DEEP MESA ETCHING OF AlGaAs-GaAs AND InGaAs-InAlAs HETEROSTRUCTURES'**

- **IBM TECHNICAL DISCLOSURE BULLETIN vol. 34, no. 3 , August 1991 , NEW YORK US page 382 XP210623 M. HEIBLUM ET AL. 'SIMKPLIFIED METHOD FOR FORMING NARROW GATES ACROSS CONDUCTION CHANNELS IN TWO-DIMENSIONAL ELECTRON-GAS HETEROSTRUCTURE DEVICES'**
- **Phys.Rev.Lett.vol.67,no.12,1991,pgs.1626-1629**

## Description

This invention relates to a method of making a charge carrier flow control device which may be used to provide a current standard, and to a device made by the method.

An electron flow control device has been proposed hitherto, which makes use of a phenomenon known as Coulomb blockade (Odintsov, A.A., Appl. Phys. Lett., 58, 2695 [1991]).

The basic phenomena of Coulomb blockade was described by Gorter C.J., Physica, 17, 777 (1951) in relation to charge carrier transport through thin films of oxidised metal grains. More recently, it has been found that a simple tunnel junction which is characterised by a very small capacitance can exhibit Coulomb blockade. For a capacitor of capacitance C, the energy that needs to be imparted to a single electron $\Delta E_c$ to force the electron into the capacitor is the charging energy of a single electron which is given by:

$$\Delta E_c = \frac{e^2}{2c} \qquad (1)$$

where e is the charge on the electron. If the capacitor is very small then this quantity can become significant in comparison to the energy supplied by an external voltage source magnitude V, which is eV. If this condition is satisfied, no current can pass through the device, and is known as Coulomb blockade of single electron tunnelling.

A single electron effect transistor, based on the Coulomb blockade effect, is disclosed by Y. Jin, B. Etienne and others, Microelectronic Engineering 17 (1992) March, pp 513-516. This uses Schottky gates to define a small island in a two dimensional electron gas system.

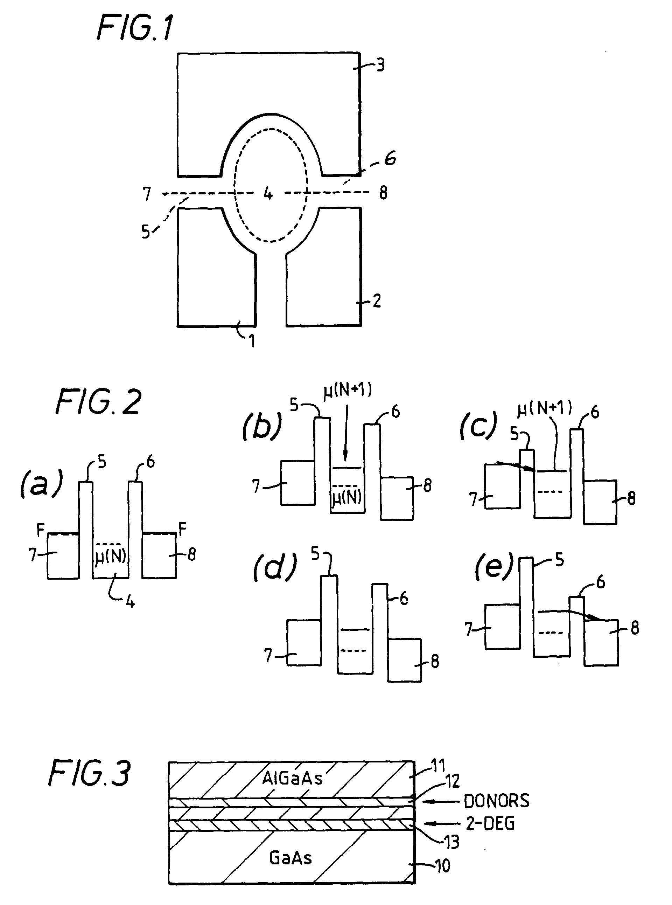

Odintsov *supra* has proposed a device in which the flow of current is controlled by a combination of two adjustable tunnelling barriers and the effect of Coulomb blockade. The device in effect operates as a turnstile so as to allow the passage of electrons in synchronism with an applied radio frequency signal. A similar device is disclosed by Kouwenhoven, L.P., Johnson, A.T., Van der Vaart, N.C. and Harmans, C.J.P.M., Phys. Rev. Lett. vol. 67, no 12 (1991) pp 1626-1629. The basic operation of the prior device will now be described with reference to Figures 1 and 2. With particular reference to Figure 1, the device consists of a semiconductor including a GaAs/GaAlAs heterojunction that provides a two dimensional electron gas. An overlaid pattern of electrodes 1, 2, 3 receives control potentials so as to establish an essentially two dimensional quantum dot 4 in the two dimensional electron gas. Additionally, the electrodes 1, 2 each cooperate with the electrode 3 to define tunnelling barrier regions 5, 6 on either side of the dot. Thus, if the region 7 to the left of the dot 4 is considered to be a source of electrons and the region 8 is considered to be a drain, individual electrons from source 7 tunnel through the barrier 5 into the dot 4 and thereafter tunnel from the dot 4 through barrier 6 to the drain 8. The tunnelling is controlled by a rf signal applied to the electrodes 1, 2.

A more detailed explanation will now be given with reference to Figure 2 which shows the potential barriers developed in use of the device. Referring to Figure 2a, this shows the equilibrium situation in which the potential barriers 5, 6 are of equal height. The energy state $\mu(N)$ of the quantum dot 4 is below the Fermi level for the source and drain regions 7, 8.

If the barriers 5, 6 each have a very small capacitance then if an electron tunnels from the source 7 through the barrier 5 into the dot 4, the energy of the dot is raised by the Coulomb energy of the electron. This is represented in Figure 2b and the increased energy level in the dot 4 is represented by $\mu(N+1)$ and is effectively the original Fermi energy shifted upward by the electrostatic charging energy. This increased energy level $\mu(N+1)$ is greater than the energy of electrons from the source and so no further electrons can enter the dot 4 from the source 7. Thus, by the effect of Coulomb blockade, only a single electron can enter the dot 4 from the source.

In order for electron transport to occur through the device, the level $\mu(N+1)$ should lie between Fermi energies of the source and drain regions as shown in Figure 2b. This condition can be achieved by moving the Fermi level in the quantum dot 4 by way of an extra gate (not shown) on the surface of the device.

In order to control the flow of electrons through the device, it is necessary to modulate the heights of the tunnel barriers 5, 6 on either side of the central dot. Referring to Figure 2c, the lefthand barrier 5 is lowered. Under such conditions, a single electron from the source will tunnel into the central region of the dot 4, raising the energy of the dot from the Nth energy level to the (N+1)th energy level marked by the solid line. Further electron tunnelling into the dot 4 from the source is prevented by Coulomb blockade. In this respect, the next available energy state (N+2) in the dot 4 is above the Fermi level in the source, and as a result no electrons can enter the (N+2) level. It will be appreciated that the temperature of the system tends to 0°K so electrons do not achieve energies that reach the (N+2) energy level in the dot.

If the barrier 5 is then raised as shown in Figure 2d, the electron will stay in the level (N+1) as it is unable to tunnel in either direction due to the size of the left and right hand barriers 5, 6.

Thereafter, as shown in Figure 2e, the right hand barrier 6 is lowered permitting the electron to tunnel out through the lowered barrier into the drain region 8. Thus, it is possible to synchronise the flow of electrons through the device by applying an external sinusoidal signal to the tunnel barriers such that their heights are modulated 180° out of phase. Thus, electrons pass through the device in the manner of a turnstile at a rate determined by the frequency of the externally applied signal.

As a practical matter, the current produced by a single gate of this type is extremely small and in order to provide a measurable current standard, it has been proposed to connect a plurality of such gates in parallel. In practice, in order to implement the device described herein, it has been necessary to construct each device such that the electrons are confined in an elongate wire in the two dimensional electron gas, with a complicated series of five gates being provided, three of which generate fields for confinement of electrons in the direction of the wire with the other two creating the adjustable tunnel barriers. If such five-gave structures were arranged in parallel, an extremely complicated electrode arrangement would be required.

In accordance with the invention, a method of making alternative structures is provided.

General techniques used for the fabrication of quantum semiconductor elements and devices, for example, quantum wires and quantum dots are known from the following documents: " Preparation of Quantum Wires and Quantum Dots by Deep Mesa Etching of Al-GaAs-GaAs AND InGaAs-InAlAs Heterostructures", P Grambow and others, 8226 Microelectronic Engineering 11(1990)April, Nos. 1/4, Amsterdam, Netherlands; "Transport characteristics of AlGaAs/GaAs wires fabricated by focused Ga-ion-beam implantation", S. Nakata and others, 931 Journal of Applied Physics 69(1991) 15 March, No. 6, New York, US, and "In-plane-gated quantum wire transistor fabricated with directly written focused ion beams", A.D. Wieck and K. Ploog, Appl Phys Lett. 56 (10) 5 March 1990, pages 928 to 930.

In accordance with the present invention as claimed in claim 1 there is provided a method of fabricating a charge carrier flow control device from a substrate that includes a region of 2-DEG, being a region of high charge mobility, the device comprising a charge storage region, means for producing first and second potential barriers for controlling charge entering and leaving the charge storage region, and means for selectively raising and lowering the barriers so that charge carriers enter and leave the charge storage region, with the passage of charge carriers into the charge storage region being limited by Coulomb blockade, the method comprising selectively subjecting the substrate to fabrication processing that confines the 2-DEG to a predetermined area of 2-DEG which defines the charge storage region.

In accordance with the present invention, there is provided a charge carrier flow control device as claimed in claim 9.

In order that the invention may be more fully understood embodiments thereof will now be described by way of example with reference to the accompanying drawing, wherein:

Figure 1 is a plan view of a prior art charge carrier flow control device;

Figure 2 illustrates operating potentials of the device of Figure 1;

Figure 3 is a cross section through a substrate for use in forming a device according to the invention;

Figure 4 illustrates schematically process steps including the application of a PMMA resist pattern and FIB implantation;

Figures 5 to 8 show in plan view the sequence of process steps;

Figure 9 shows in plan view a first example of a device produced by the method shown in Figures 5 to 8; and

Figure 10 shows an alternative form of the device.

In accordance with an embodiment of the invention, a charge storage region is produced in a two dimensional electron gas, by confining the gas to a particular region using focussed ion beam (FIB) techniques.

Referring to Figure 3, a substrate including a heterojunction between a GaAs layer 10 and a AlGaAs layer 11 that includes doped donor impurities 12, produces a two dimensional region of high electron mobility 13 known as a two dimensional electron gas 13 also known as a 2-DEG.

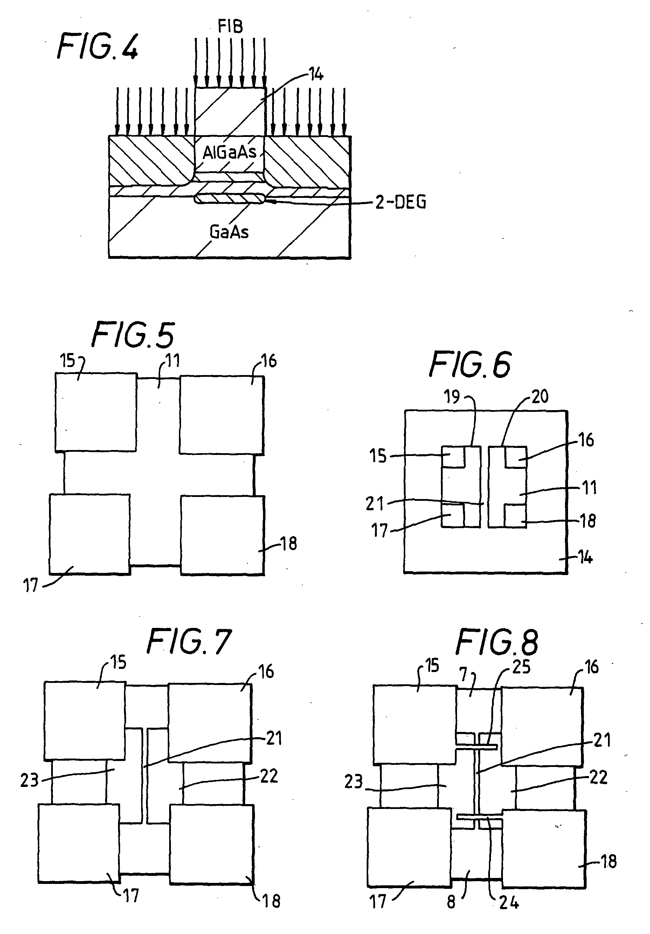

As shown in Figure 4, the two dimensional electron gas 13 is constrained to a small region defining an elongate wire structure by the implantation of ions into the AlGaAs layer 11 using an FIB. The beam strength is selected so that sufficient numbers of ions are injected into the crystal so as to neutralise the donor impurities 12 in the AlGaAs layer 11 with the result that the two dimensional electron gas at the heterojunction ceases to exist in the ion-doped regions. In order to prevent the two dimensional electron gas being destroyed in the wire region, a resist pattern is applied to the surface of the wafer. Typically, a PMMA resist is applied to the surface and then a pattern is written into the resist using electron beam lithography techniques. When the structure is irradiated with ions from the FIB, the heterojunction underneath the resist covered areas is undamaged whereas for the substrate left exposed, the ions implant into the surface destroying the two dimensional electron gas.

After formation of an electron wire in this manner, gate patterns are applied in order to create tunnel barriers at opposite ends of the wire. The process step for the fabrication of the device will now be described in more detail with reference to Figures 5 to 8.

Referring firstly to Figure 5, a GaAs/GaAlAs heterojunction is formed on a substrate so as to define a two dimensional electron gas in the manner shown in section in Figure 3. Fabrication of such a junction is well known in the art and will not be described in detail herein. As shown in plan view in Figure 5, the two dimensional electron gas is formed in a cruciform configuration with four desposited metal gate regions 15, 16, 17, 18 being formed therein.

Referring now to Figure 6, the layer of PMMA resist is spun onto the surface of the substrate and two windows 19, 20 are opened in the resist using an electron beam. A thin line of resist 21 is left on the substrate between the opening 19, 20 in order to define an elongate wire in the two dimensional electron gas 13 as will be explained hereinafter.

Referring to Figure 7, the substrate is thereafter subjected to FIB exposure, typically with a source of gallium ions, which produces implantation in the AlGaAs layer 11 in regions 22, 23 corresponding to the windows 19, 20. No implantation occurs in the region 21 due to the shielding effect of the PMMA resin. The regions 15-18 are unaffected by the FIB implantation as they are shielded by metal surface gates. As a result, an essentially two dimensional electron wire structure is formed beneath the region 21 in the two dimensional electron gas. As previously explained, the effect of the gallium ion implantation is to destroy the two dimensional electron gas in the regions 22, 23 so that the wire is in effect surrounded by regions of very low conductivity, so as to define the wire, without the need for external applied fields as in the prior art.

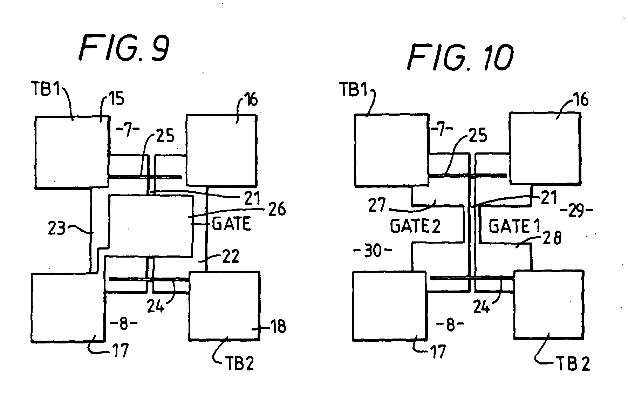

Referring to Figure 8, tunnelling barriers are formed at opposite ends of the wire 21 by means of electrode regions 24, 25 which extend transversely across the wire and are connected to gate regions 15, 18 respectively. The electrode regions 24, 25 are typically written onto the surface of the substrate by electron beam techniques.

Thus, the region 7 of the two dimensional electron gas can be considered as the source of the device, the region 8 can be considered the drain and the region 21 of the wire between the tunnelling barriers 24, 25 can be considered as a charge storage region.

Referring to Figure 9, a metalisation overlayer can be applied to the gate regions 15 - 18 to form appropriate contacts. Thus, the region 15 defines a contact TB1 for the tunnelling barrier 25, and region 16 forms an isolation contact to shepherd the carriers through the central channel, 21. Region 17 provides a means of connecting the control gate 26, whereby the Schottky gate 26, which overlays the channel region produces a means of "tuning" the energy levels of the charge storage region, 21 to the correct level for operation of the device. In an alternative arrangement shown in Figure 10, the FIB implanted regions 22, 23 are arranged to define a pattern of FIB implantation that provides re-entrant regions 27, 28 which constitute in-plane gates connected to the 2-DEG gas 29, 30 that surrounds the wire 21. The electron gas regions 29, 30 are coupled to independent contacts (not shown) which allow the application of an external bias to the central/channel region 21 of the wire.

It will be appreciated that the resulting structure is effectively a transistor which operates by manipulating the flow of single electrons. Thus, in use, rf signals 180° out of phase are applied to the electrodes TB1, TB2 so as to raise and lower cyclicly the tunnelling barriers produced by electrode regions 24, 25. As a result, the device operates in a manner analogous to that described with reference to Figure 2. Thus, when the barrier defined by the electrode 25 is momentarily reduced, a single electron can tunnel through the barrier into the wire 21. The energy levels are so arranged that only a single electron can tunnel into the region 21. Further electron tunnelling is inhibited by Coulomb blockade, i.e. the energy level of the next state permissible in the region 21 is greater than the tunnelling energy of a second electron so that the second electron cannot enter the region 21 when the barrier potential of region 25 is lowered.

Thereafter, the height of the tunnelling barrier associated with electrode 24 is momentarily lowered and as a result a single electron tunnels through the barrier into the drain 8.

In a practical implementation of the described device, the FIB implants 22, 23 may exhibit p- or n-type characteristics so that the gate 26 may make an electrical connection with the regions 22, 23 that would cause the channel in wire 21 to be widened or narrowed depending on the polarity of the applied voltage. Similar comments apply in relation to gates 15 - 18. In order to prevent this, it may be necessary to include an insulating layer (not shown) between the gates and the FIB implants.

In order to produce a quantum current standard, as discussed before, it may be necessary to include a plurality of such devices connected in parallel. By the aforedescribed methods, a plurality of parallel channels can be fabricated simultaneously. The metal gates which are used to create the tunnel barriers in the device can then be simply extended over the array of channels. In this case, the tuning of the levels in the central region of each resulting channel can be achieved by means of respective surface gate such as gate 26 shown in Figure 9.

With such an array of parallel wires, each desirably should be formed to have identical electrical characteristics so that the accuracy of the current obtained is not degraded relative to that obtainable with a single device. The main effect of geometrical inaccuracies in the wire and gate sizes will result in a spread in the essentially quantised magnitude of charging energy. For present devices, the associated charging energy is of the order of 6°K (expressed as a termpature). It can be shown that if the gates are fabricated with tolerances of 10-20%, the error in the charging energy is approximately in the same range (approximately 15-30%) leading to a fluctuation in charging energy across the whole array of around 1K. If the temperature of the two dimensional electron gas is held approximately to 0.1K, then the effects of thermal broadening will be sufficiently low that Coulomb blockade will be simultaneously observed in all wires in an array structure. Thus, it appears that the device can count single electrons which would enable a standard electric current to be established which is referenced to a standard of frequency i.e. the frequency applied to the tunnel barriers TB1, 2.

## Claims

1. A method of fabricating a charge carrier flow control device from a substrate (10, 11, 12) that includes a region of 2-DEG (13), being a region of high charge mobility, the device comprising a charge storage region (21), means (24, 25) for producing first and second potential barriers for controlling charge entering and leaving the charge storage region, and means (15, 18) for selectively raising and lowering the barriers so that charge carriers enter and leave the charge storage region, with the passage of charge carriers into the charge storage region being limited by Coulomb blockade, **characterised by** selectively carrying out destruction of the 2-DEG by means of a focused ion beam such as to confine the 2-DEG to a predetermined area (21) which defines the charge storage region.

2. A method according to claim 1 including injecting gallium ions into an AlGaAs layer (11) in the substrate to cancel the effect of donor atoms therein in a pattern to define the charge storage region (21).

3. A method according to claim 1 or 2 including forming electrodes (24, 25) on the substrate overlying the area of 2-DEG, for providing said potential barriers.

4. A method according to claim 3 including forming said electrodes (24, 25) by subjecting an electron beam sensitive polymeric resist to electron exposure.

5. A method according to any preceding claim including configuring the predetermined area of 2-DEG (21) as an elongate wire.

6. A method according to any preceding claim including forming gate regions (16, 17) coupled to source (7) and drain (8) regions respectively, with said charge storage region (21) and said potential barriers (24, 25) being disposed between said source and drain regions.

7. A method according to claim 6 including forming a further gate overlying the charge storage region for controlling the Fermi level therein relative to the Fermi levels of the source and gate regions.

8. A method according to claim 6 or 7 including forming further gate regions connected to said electrodes which respectively define said potential barriers.

9. A charge carrier flow control device comprising a substrate (10, 11, 12) that includes a region of 2-DEG (13), being a region of high charge carrier mobility, a charge storage region (21), means (24, 25) for producing first and second potential barriers for controlling charge entering and leaving the charge storage region, and means (15, 18) for selectively raising and lowering the barriers so that charge carriers can enter and leave the charge storage region, with the passage of charge carriers into the charge storage region being limited by Coulomb blockade, **characterised in that** the 2-DEG region has been selectively destroyed by means of a focused ion beam such as to confine the 2-DEG to a predetermined area (21) which defines the charge storage region.

## Patentansprüche

1. Verfahren zur Herstellung einer Ladungsträger-Flusssteuerungsvorrichtung aus einem Substrat (10, 11, 12), das einen 2-DEG-Bereich (13) enthält, der ein Bereich mit hoher Ladungsträgerbeweglichkeit ist, wobei die Vorrichtung einen Ladungsspeicherbereich (21), eine Einrichtung (24, 25) zur Erzeugung von ersten und zweiten Potentialbarrieren zur Steuerung von Ladung, die in den Ladungsspeicherbereich eintritt und ihn verlässt, und eine Einrichtung (15, 18) zum selektiven Erhöhen und Erniedrigen der Barrieren aufweist, so dass Ladungsträger in den Ladungsspeicherbereich eintreten und ihn verlassen, wobei der Durchgang von Ladungsträgern in den Ladungsspeicherbereich durch Coulomb-Blockade begrenzt wird, **gekennzeichnet durch** selektive Durchführung einer Zerstörung des 2-DEG mittels eines fokussierten Ionenstrahls, derart, dass das 2-DEG auf ein vorbestimmtes Gebiet (21) eingeschränkt wird, das den Ladungsspeicherbereich definiert.

2. Verfahren nach Anspruch 1, bei dem man in einem Muster zum Definieren des Ladungsspeicherbereiches (21) Gallium-Ionen in eine AlGaAs-Schicht (11) im Substrat injiziert, um die Wirkung von Donatoratomen darin aufzuheben.

3. Verfahren nach Anspruch 1 oder 2, bei dem man Elektroden (24, 25) auf dem über dem 2-DEG-Gebiet legenden Substrat bildet, um die Potentialbarrieren zu erzeugen.

4. Verfahren nach Anspruch 3, bei dem man die Elektroden (24, 25) bildet, indem man eine elektronenstrahlempfindliche polymerische Abdeckung Elektronenbestrahlung unterzieht.

**5.** Verfahren nach irgendeinem vorhergehenden Anspruch, bei dem man das vorbestimmte 2-DEG-Gebiet (21) als eine langgestreckte Leitung gestaltet.

**6.** Verfahren nach irgendeinem vorhergehenden Anspruch, bei dem man Gate-Bereiche (16, 17) bildet, die mit Source- (7) bzw. Drain(8)-Bereichen verbunden sind, wobei der Ladungsspeicherbereich (21) und die Potentialbarrieren (24, 25) zwischen den Source- und Drain-Bereichen angeordnet sind.

**7.** Verfahren nach Anspruch 6, bei dem man ein weiteres Gate bildet, das über dem Ladungsspeicherbereich liegt, um das Fermi-Niveau darin relativ zu den Fermi-Niveaus der Source- und Gate-Bereiche zu steuern.

**8.** Verfahren nach Anspruch 6 oder 7, bei dem man weitere Gate-Bereiche bildet, die mit den Elektroden verbunden sind, die jeweils die Potentialbarrieren definieren.

**9.** Ladungsträger-Flusssteuerungsvorrichtung mit einem Substrat (10, 11, 12), das einen 2-DEG-Bereich (13), der ein Bereich mit hoher Ladungsträgerbeweglichkeit ist, einem Ladungsspeicherbereich (21), einer Einrichtung (24, 25) zur Erzeugung von ersten und zweiten Potentialbarrieren zur Steuerung von Ladung, die in den Ladungsspeicherbereich eintritt und ihn verlässt, und einer Einrichtung (15, 18) zum selektiven Erhöhen und Erniedrigen der Barrieren enthält, so dass Ladungsträger in den Ladungsspeicherbereich eintreten und ihn verlassen können, wobei der Durchgang von Ladungsträgern in den Ladungsspeicherbereich durch Coulomb-Blockade begrenzt wird, **dadurch gekennzeichnet, dass** der 2-DEG-Bereich selektiv mittels eines fokussierten Ionenstrahls zerstört worden ist, derart, dass das 2-DEG auf ein vorbestimmtes Gebiet (21) eingeschränkt wird, das den Ladungsspeicherbereich definiert.

**Revendications**

**1.** Procédé de fabrication d'un dispositif de commande d'écoulement de porteurs de charges à partir d'un substrat (10, 11, 12) qui comprend une région de 2-DEG (13), qui est une région à haute mobilité de charges, le dispositif comportant une région (21) de stockage de charges, des moyens (24, 25) destinés à produire des première et seconde barrières de potentiel pour commander une charge entrant dans la région de stockage de charges et en sortant, et des moyens (15, 18) destinés à sélectivement élever et abaisser les barrières afin que des porteurs de charges entrent dans la région de stockage de charges et en sortent, le passage de porteurs de charges en entrée dans la région de stockage de charges étant limité par blocage de Coulomb, caractérisé par l'exécution sélective d'une destruction de la région 2-DEG au moyen d'un faisceau ionique focalisé afin de confiner la région de 2-DEG à une zone prédéterminée (21) qui définit la région de stockage de charges.

**2.** Procédé selon la revendication 1, comprenant l'injection d'ions gallium dans une couche (11) d'AlGaAs dans le substrat pour y annuler l'effet d'atomes donneurs suivant un motif destiné à définir la région (21) de stockage de charges.

**3.** Procédé selon la revendication 1 ou 2, comprenant la formation d'électrodes (24, 25) sur le substrat s'étendant au-dessus de la zone de 2-DEG, pour produire lesdites barrières de potentiel.

**4.** Procédé selon la revendication 3, comprenant la formation desdites électrodes (24, 25) en soumettant un résist polymérique sensible à un faisceau d'électrons à une exposition à des électrons.

**5.** Procédé selon l'une quelconque des revendications précédentes, comprenant la configuration de la zone prédéterminée de 2-DEG (21) sous la forme d'un fil allongé.

**6.** Procédé selon l'une quelconque des revendications précédentes, comprenant la formation de régions de grilles (16, 17) couplées, respectivement, à des régions de sources (7) et de drains (8), ladite région (21) de stockage de charges et lesdites barrières de potentiel (24, 25) étant disposées entre lesdites régions de sources et de drains.

**7.** Procédé selon la revendication 6, comprenant la formation d'une autre grille s'étendant au-dessus de la région de stockage de charges pour y commander le niveau de Fermi par rapport aux niveaux de Fermi des régions de sources et de grilles.

**8.** Procédé selon la revendication 6 ou 7, comprenant la formation d'autres régions de grilles connectées auxdites électrodes qui définissent, respectivement, lesdites barrières de potentiel.

**9.** Dispositif de commande d'écoulement de porteurs de charges comportant un substrat (10, 11, 12) qui comprend une région de 2-DEG (13), qui est une région à haute mobilité de porteurs de charges, une région (21) de stockage de charges, des moyens (24, 25) destinés à produire des première et seconde barrières de potentiel pour commander l'entrée de charges dans la région de stockage de charges et leur sortie de cette région, et des moyens (15, 18) destinés sélectivement à élever et abaisser les barrières afin que des porteurs de charges puissent entrer dans la région de stockage de charges et en sortir, le passage de porteurs de charges en entrée dans la région de stockage de charges étant limité par un blocage de Coulomb, caractérisé en ce que la région 2-DEG a été détruite sélectivement au moyen d'un faisceau ionique focalisé afin de confiner le 2-DEG à une zone prédéterminée (21) qui définit la région de stockage de charges.

FIG.1

FIG.2

FIG.3

FIG.4

FIG.5

FIG.6

FIG.7

FIG.8

## FIG. 9

TB1
15
-7-
25
16
21
26
GATE
23
22
24
-8-
17
18
TB2

## FIG. 10

TB1
-7-
25
16
27
21
-29-
GATE 2
GATE 1
28
-30-
22
24
-8-
17
TB2